Europäisches Patentamt

European Patent Office

Office européen des brevets

(11) Veröffentlichungsnummer: **0 293 607**
**B1**

(12) **EUROPÄISCHE PATENTSCHRIFT**

(45) Veröffentlichungstag der Patentschrift:
07.11.90

(51) Int. Cl.⁵: **C23C 14/56**, H01J 37/34,
H01J 37/32

(21) Anmeldenummer: 88106952.0

(22) Anmeldetag: 29.04.88

(54) **Vorrichtung zum Aufstäuben dünner Schichten auf ein Substrat.**

(30) Priorität: 26.05.87 DE 3717764

(43) Veröffentlichungstag der Anmeldung:
07.12.88 Patentblatt 88/49

(45) Bekanntmachung des Hinweises auf die Patenterteilung:
07.11.90 Patentblatt 90/45

(84) Benannte Vertragsstaaten:
AT DE FR GB IT NL

(56) Entgegenhaltungen:
US-A- 4 420 385

PATENT ABSTRACTS OF JAPAN, Band 7,
Nr. 3 (C-143)[1148], 7. Januar 1983, Seite C143; &
JP-A-57 161 065 (FUJITSU K.K.) 04-10-1982

(73) Patentinhaber: Siemens Aktiengesellschaft,
Wittelsbacherplatz 2, D-8000 München 2(DE)

(72) Erfinder: Kohlhase, Armin, Dr., Unterhachinger
Strasse 85d, D-8000 München 83(DE)
Erfinder: Birkmaier, Georg, Heinrich-Vogl-Strasse 4,
D-8017 Ebersberg(DE)
Erfinder: Wienerrolther, Friedrich, Untersbergstrasse 2,
D-8000 München 90(DE)

**Beschreibung**

Die Erfindung betrifft eine Vorrichtung zum Austäuben dünner Schichten auf ein Substrat, mit mindestens zwei evakuierbaren und mit einem inerten Gas beaufschlagbaren Kammern, wobei in mindestens eine der Kammern zusätzlich über ein Absperrventil und einen Durchflußregler ein reaktives Gas einleitbar ist.

Bei der häufig auch als Sputtern bezeichneten Kathodenzerstäubung werden im Vakuum mittels in einer Gasentladung gebildeter Ionen eines inertes Gases Atome von einer Kathode herausgelöst, die sich dann auf einem gegenüber angeordneten Substrat niederschlagen. Bei einer Variante dieser Aufstäubtechnik, dem sogenannten reaktiven Aufstäuben oder reaktiven Sputtern wird nicht das Quellenmaterial selbst abgeschieden, sondern eine durch Reaktion mit einem reaktiven Gas entstehende Verbindung.

Bei der Herstellung von Megabit-Speichern werden zur Bildung von Kontakten und Leiterbahnen auf die einzelnen Wafer dünne Schichten aus Titan, Titannitrid und Aluminium nacheinander in verschiedenen Kammern aufgestäubt. Während beim Aufstäuben des Titans und des Aluminiums lediglich Argon als inertes Gas in die betreffenden Kammern eingeleitet wird, muß beim reaktiven Aufstäuben des Titannitrids zusätzlich noch Stickstoff als reaktives Gas in die zugeordnete Kammer eingeleitet werden. Die Zufuhr des inerten Gases und des reaktiven Gases erfolgt dabei jeweils über ein Absperrventil und einen Durchflußregler. Um eine Querverschmutzung zwischen den einzelnen Kammern der Aufstäubvorrichtung durch das reaktive Gas ausschließen zu können, muß das reaktive Gas vor dem Wafertransport und insbesondere vor dem Öffnen der für den Durchtritt der Wafer erforderlichen Schlitzventile zu den benachbarten Kammern abgepumpt werden. Wenn danach der nächste Wafer prozessiert werden soll, muß dann wieder neben dem inerten Gas neues reaktives Gas in die Kammer eingeleitet werden und dabei die Gasflüsse stabilisiert werden. Im Hinblick auf das in der Kammer erforderliche Hochvakuum von $10^{-4}$ bis $10^{-5}$ Pa erfordert das Abpumpen des alten reaktiven Gases bzw. des Reaktionsgasgemisches eine relativ lange Zeit von mehreren Minuten. Desgleichen nimmt das Einlassen und Stabilisieren des neuen reaktiven Gases eine im Hinblick auf den erwünschten Durchsatz zu lange Zeit in Anspruch.

Der Erfindung liegt die Aufgabe zugrunde, eine Vorrichtung zum Aufstäuben dünner Schichten auf ein Substrat zu schaffen, bei welcher das Abpumpen des alten reaktiven Gases nach dem reaktiven Aufstäuben sowie das Einlassen und Stabilisieren des neuen reaktiven Gases wesentlich weniger Zeit als bislang erfordert.

Diese Aufgabe wird bei einer Vorrichtung der eingangs genannten Art erfindungsgemäß dadurch gelöst, daß dem absperrbar ausgebildeten Durchflußregler ein zweites Absperrventil nachgeordnet ist und daß das erste Absperrventil, der Durchflußregler und das zweite Absperrventil synchron absperrbar sind.

Durch das dem Durchflußregler nachgeordnete und unmittelbar vor der Kammer angeordnete zweite Absperrventil wird das Abpumpen des alten reaktiven Gases wesentlich beschleunigt, da das Evakuieren des Leitungsstranges bis zum ersten Absperrventil und das Evakuieren des Durchflußreglers selbst entfällt. Desgleichen müssen beim Einleiten des neuen reaktiven Gases dieser Leitungsstrang und der Durchflußregler nicht mehr gefüllt werden. Für sich allein gesehen würde diese Maßnahme aber noch nicht zum gewünschten Erfolg führen, da bei einem gleichzeitigen Absperren der beidseitig des Durchflußreglers angeordneten Absperrventile der Durchflußregler in seiner Funktion als Regelglied einen Druckanstieg vor dem zweiten Absperrventil bewirken würde. Hierdurch würde dann beim Öffnen der Absperrventile ein in die Kammer gerichteter Druckstoß auftreten, der zu einer Überlastung der Vakuummeßsysteme und zu einem Ansprechen des Überlastschutzes, d.h. zum Ausschalten der Vorrichtung führen könnte. Ein derartiger Druckstoß wird jedoch dadurch vermieden, daß der Durchflußregler absperrbar ausgebildet ist und gleichzeitig mit den zu seinen beiden Seiten angeordneten Absperrventilen abgesperrt wird.

Gemäß einer bevorzugten Ausgestaltung der Erfindung sind die beiden Absperrventile gemeinsam pneumatisch betätigbar. Derartige pneumatisch betätigbare Absperrventile haben gegenüber Magnetventilen den Vorteil, daß sie nicht heiß und damit undicht werden. Undichte Absperrventile könnten nämlich zu einer Verschmutzung der Prozeßgase führen. Außerdem kann bei der Umrüstung einer konventionellen Vorrichtung durch den Einbau pneumatischer Absperrventile eine Überlastung des Schaltkreises vermieden werden.

Gemäß einer weiteren bevorzugten Ausgestaltung der Erfindung ist das inerte Gas ebenfalls über ein erstes Absperrventil, einen absperrbar ausgebildeten Durchflußregler und ein zweites Absperrventil in die Kammer einleitbar, wobei das erste Absperrventil, der Durchflußregler und das zweite Absperrventil synchron absperrbar sind. Somit ergeben sich dann auch für das inerte Gas die bereits im Zusammenhang mit dem reaktiven Gas geschilderten Vorteile. Eine derartige Anordnung ist dabei insbesondere für die für das reaktive Aufstäuben vorgesehene Kammer von erheblicher Bedeutung, da die rasche Stabilisierung beider Gasflüsse eine genaue Einhaltung des erforderlichen Verhältnisses von reaktivem Gas zu inertem Gas ermöglicht.

Ein Ausführungsbeispiel der Erfindung ist in der Zeichnung dargestellt und wird im folgenden näher beschrieben. Es zeigen

Fig. 1 eine Vorrichtung zum Aufstäuben dünner Schichten auf ein Substrat in stark vereinfachter schematischer Darstellung und

Fig. 2 Einzelheiten der Einleitung eines reaktiven Gases in eine der Kammern der in Fig. 1 dargestellten Vorrichtung.

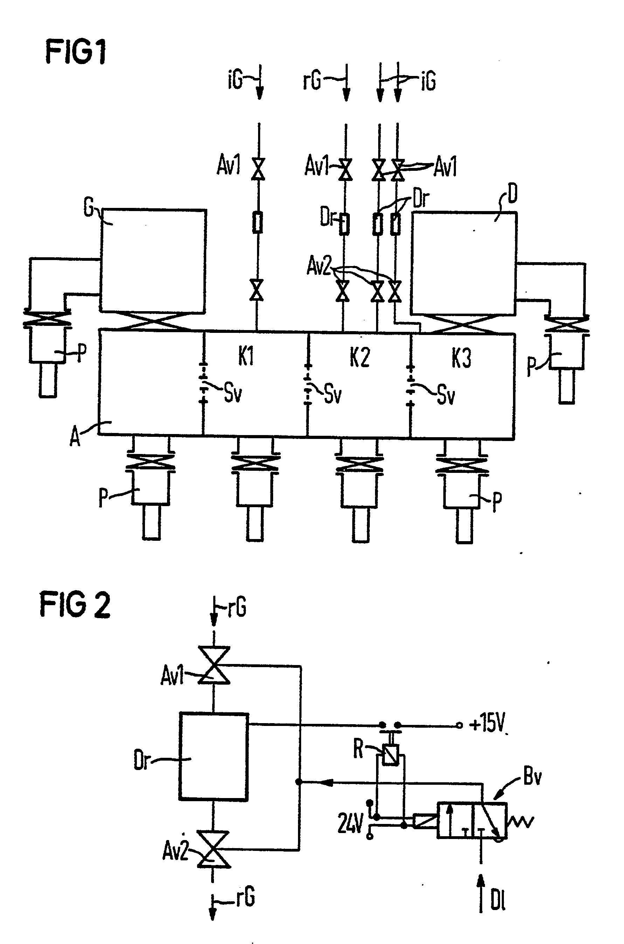

Fig. 1 zeigt in stark vereinfachter schematischer Darstellung eine Vorrichtung zum Aufstäuben dünner Schichten auf ein Substrat, die beispielsweise bei der Herstellung von Megabit-Speichern für das Aufbringen von Titan, Titannitrid und Aluminium auf die Wafer eingesetzt wird. Die einzelnen Substrate durchlaufen dabei eine Chargierschleuse C, eine Ätzkammer A, eine Kammer K1 zum Aufstäuben einer ersten dünnen Schicht, eine Kammer K2 zum reaktiven Aufstäuben einer zweiten dünnen Schicht, eine Kammer K3 zum Aufstäuben einer dritten dünnen Schicht und eine Dechargierschleuse D. Es ist zu Erkennen, daß die Chargierschleuse C, die Äztkammer A, die Kammern K1 bis K3 und die Dechargierschleuse D jeweils mit Hilfe einer schematisch dargestellten Pumpe P evakuiert werden können, wobei zumindest in den Kammern K1 bis K3 ein Hochvakuum von $10^{-4}$ bis $10^{-5}$ Pa erforderlich ist. Zwischen der Ätzkammer A und der Kammer K1, zwischen der Kammer K1 und der Kammer K2 sowie zwischen der Kammer K2 und der Kammer K3 befindet sich jeweils ein Schlitzventil Sv, das im geöffneten Zustand den Durchtritt eines Wafers mit Hilfe eines nicht näher dargestellten Wafertransportsystems ermöglicht.

In die Kammern K1 bis K3 ist jeweils über ein erstes Absperrventil Av1, einen Durchflußregler Dr und über ein zweites Absperrventil Av2 ein durch Pfeile aufgezeigtes inertes Gas iG, beispielsweise Argon, einleitbar. Ferner ist in die Kammer K2 ebenfalls wieder über ein erstes Absperrventil Av1, einen Durchflußregler Dr und über ein zweites Absperrventil Av2 ein durch einen Pfeil aufgezeigtes reaktives Gas rG, beispielsweise Stickstoff, einleitbar.

Fig. 2 zeigt nähere Einzelheiten der für die Einleitung des reaktiven Gases rG verwendeten Anordnung der beiden Absperrventile Av1 und Av2 und des Durchflußreglers Dr. Eine identisch ausgebildete Anordnung wird auch für die Einleitung des inerten Gases iG verwendet. Es ist zu erkennen, daß mit einer Steuerspannung von 24 V Wechselstrom gleichzeitig ein magnetgesteuertes und als 3/2 Wegeventil ausgebildetes Betätigungsventil Bv und ein Relais R angesteuert werden können.

Das Betätigungsventil Bv steuert dabei die gleichzeitige Beaufschlagung der im Normalzustand geschlossenen Absperrventile Av1 und Av2 mit Druckluft D1. Das Relais R steuert demgegenüber die Beaufschlagung des im Normalzustand geschlossenen Durchflußreglers Dr mit einer Betätigungsspannung von +15 V Gleichstrom gegen Masse. Es ist zu erkennen, daß über die Steuerspannung von 24 V die beiden Absperrventile Av1 und Av2 und der Durchflußregler Dr synchron abgesperrt bzw. geöffnet werden können.

Nach dem reaktiven Aufstäuben in der Kammer K2 müssen deren Schlitzventile Sv geöffnet werden, so daß das in der Kammer K2 bereits behandelte Substrat in die Kammer K3 transportiert werden kann und auch das in der Kammer K1 behandelte Substrat in die Kammer K2 transportiert werden kann. Damit bei diesem Transportvorgang kein reaktives Gas rG in die Kammern K1 und K3 gelangen kann, wird vor dem Öffnen der Schlitzventile Av die weitere Zufuhr von reaktivem Gas rG in die Kammer K2 durch gleichzeitiges Absperren der betreffenden Absperrventile Av1 und Av2 und des betreffenden Durchflußreglers Dr unterbrochen. Gleichzeitig mit diesem Vorgang wird aber auch die weitere Zufuhr von inertem Gas iG in die Kammer K2 durch gleichzeitiges Schließen der betreffenden Absperrventile Av1 und Av2 und des betreffenden Durchflußreglers Dr unterbrochen. Erst nach dem Abpumpen des in der Kammer K2 vorhandenen Reaktionsgasgemisches über die zugeordnete Pumpe P werden dann die Schlitzventile Sv für den Transport der Substrate geöffnet. Nach dem Transport der Substrate und nach dem erneuten Schließen der Schlitzventile Sv werden dann sämtliche Absperrventile Av1 und Av2 und Durchflußregler Dv wieder geöffnet, wobei sich unter Vermeidung eines Druckstoßes eine rasche Stabilisierung der beiden Gasflüsse ergibt. In gleicher Weise wird auch die Einleitung von inertem Gas iG in die Kammern K1 und K3 gesteuert.

Bei der vorstehend anhand der Fig. 1 und 2 beschriebenen Vorrichtung zum Aufstäuben dünner Schichten auf ein Substrat handelt es sich um eine im Hinblick auf den erfindungsgemäßen Gaseinlaß modizifierte Aufstäubanlage Modell MCH-9000 der ULVAC Corp., 2500, Hagisono, Chigasaki, Kanagwa 253, Japan. Dabei wurden für die erwähnte Modifikation als Durchflußregler Dr ein "FC-280-S Ultrafast Flow Controller" der Firma Tylan GmbH, D-8057 Eching und als Absperrventile Av1 und Av2 pneumatische Ventile des Typs "Nuproventil SS4 BK-1C" der Firma Druckluft Ebel, D-8033 Martinsried verwendet.

**Patentansprüche**

1. Vorrichtung zum Aufstäuben dünner Schichten auf ein Substrat, mit mindestens zwei evakuierbaren und mit einem inerten Gas beaufschlagbaren Kammern, wobei in mindestens eine der Kammern zusätzlich über ein Absperrventil und einen Durchflußregler ein reaktives Gas einleitbar ist, **dadurch gekennzeichnet,** daß dem absperrbar ausgebildeten Durchflußregler (Dr) ein zweites Absperrventil (Av2) nachgeordnet ist und daß das erste Absperrventil (Av1), der Durchflußregler (Dr) und das zweite Absperrventil (Av2) synchron absperrbar sind.

2. Vorrichtung nach Anspruch 1, **dadurch gekennzeichnet,** daß die beiden Absperrventile (Av1,Av2) gemeinsam pneumatisch betätigbar sind.

3. Vorrichtung nach Anspruch 1 oder 2, **dadurch gekennzeichnet,** daß das inerte Gas (iG) ebenfalls über ein erstes Absperrventil (Av1), einen absperrbar ausgebildeten Durchflußregler (Dr) und ein zweites Absperrventil (Av2) in die Kammern (K1,K2,K3) einleitbar ist, wobei das erste Absperrventil (Av1), der Durchflußregler (Dr) und das zweite Absperrventil (Av2) synchron absperrbar sind.

## Claims

1. Device for sputtering thin layers on a substrate, comprising at least two chambers which are evacuatable and can be charged with an inert gas, it additionally being possible for a reactive gas to be introduced into at least one of the chambers via a shut-off valve and a flow governor, characterized in that a second shut-off valve (Av2) is located downstream of the closably constructed flow governor (Dr), and in that the first shutoff valve (Av1), the flow governor (Dr) and the second shut-off valve (Av2) can be closed synchronously.

2. Device according to Claim 1, characterized in that the two shut-off valves (Av1, Av2) can be operated jointly pneumatically.

3. Device according to Claim 1 or 2, characterized in that the inert gas (iG) can likewise be introduced into the chambers (K1, K2, K3) via a first shut-off valve (Av1), a closably constructed flow governor (Dr) and a second shut-off valve (Av2), the first shut-off valve (Av1), the flow governor (Dr) and the second shut-off valve (Av2) being closable synchronously.

## Revendications

1. Dispositif de pulvérisation de couches minces sur un substrat, comprenant au moins deux chambres pouvant être mises sous vide et pouvant être alimentées en un gaz inerte, un gaz réactif pouvant être introduit, en outre, dans l'une au moins des chambres par une vanne d'arrêt et par un régulateur d'écoulement, caractérisé, en ce qu'une seconde vanne d'arrêt (Av2) est montée en aval du régulateur d'écoulement (Dr) constitué de manière à pouvoir être fermé, et en ce que la première vanne d'arrêt (Av1), le régulateur d'écoulement (Dr) et la seconde vanne d'arrêt (Av2) peuvent être fermés en synchronisme.

2. Dispositif suivant la revendication 1, caractérisé, en ce que les deux vannes d'arrêt (Av1, Av2) peuvent être manœuvrées pneumatiquement en commun.

3. Dispositif suivant la revendication 1 ou 2, caractérisé, en ce que le gaz inerte (iG) peut être introduit dans les chambres (K1, K2, K3) également par une première vanne d'arrêt (Av1), par un régulateur d'écoulement (Dr) constitué de manière à pouvoir être fermé, et par une seconde vanne d'arrêt (Av2), la première vanne d'arrêt (Av1), le régulateur d'écoulement (Dr) et la seconde vanne d'arrêt (Av2) pouvant être fermés en synchronisme.

## FIG 1

## FIG 2